# FASCICULE DE BREVET EUROPEEN

(11) **EP 0 582 527 B1**
(45) Date de publication et mention de la délivrance du brevet: **09.12.1998**
(21) Numéro de dépôt: 93420301.9
(22) Date de dépôt: 13.07.1993
(51) Int. Cl.: G01R 31/36

(54) **Dispositif de détection de défaillance d'éléments de batterie**
Einrichtung zur Detektion des Ausfallens von Zellen einer Batterie
Device for detection faults in cells of a battery

(30) Priorité: 05.08.1992 FR 9209819
(43) Date de publication de la demande: 09.02.1994
(73) Titulaire: MGE-UPS SYSTEMS, 38240 Meylan (FR)
(72) Inventeur: Fiorina, Jean-Noel, F-38050 Grenoble Cédex 09 (FR); Lailler, Patrick, F-38050 Grenoble Cédex 09 (FR)
(74) Mandataire: Jouvray, Marie-Andrée

(56) Documents cités:
- FR-A- 2 591 822
- US-A- 4 322 685
- US-A- 5 061 898

## Description

L'invention concerne un dispositif de détection de défaillance d'éléments de batterie comportant des moyens de mesure, pendant la décharge de la batterie, de la tension aux bornes de la batterie.

Les batteries d'accumulateurs, notamment celles utilisées dans les alimentations sans coupure, sont généralement constituées d'un certain nombre d'éléments connectés en série. Jusqu'ici la détection de la défaillance d'un ou plusieurs éléments de batterie ne peut être effectuée que par la surveillance de la tension individuelle aux bornes de chaque élément. Ceci implique une mesure d'un nombre important de tensions et l'accessibilité des bornes des différents éléments.

Le document US-A- 4.322.685 décrit un analyseur de batteries qui réalise quatre tests successifs pour détecter la défaillance d'un élément de batterie. Le quatrième test consiste à connecter la batterie à une résistance fixe, très faible, pendant 20s et à mesurer la tension aux bornes de la batterie. Si cette tension augmente de plus de 0,17V pendant une période prédéterminée de la durée du test, la batterie est considérée comme défaillante.

L'invention a pour but un dispositif de détection de défaillance d'un ou plusieurs éléments de batterie plus simple et ne présentant pas les inconvénients précités.

Selon l'invention, ce but est atteint par le fait que le dispositif comporte des moyens de calcul d'une grandeur représentative de la dérivée seconde de ladite tension, des moyens de comparaison de ladite grandeur représentative de la dérivée seconde à un seuil prédéterminé, positif ou nul, et des moyens de signalisation d'une défaillance lorsque ladite grandeur est supérieure audit seuil.

Selon un mode de réalisation préférentiel le dispositif met en mémoire trois valeurs successives de la tension aux bornes de la batterie, mesurées à des intervalles de temps prédéterminés, et calcule à partir de ces trois valeurs deux valeurs successives d'une grandeur représentative de la dérivée première de la tension. Il calcule ensuite la grandeur représentative de la dérivée seconde en calculant la différence entre les deux valeurs successives de la grandeur représentative de la dérivée première.

D'autres avantages et caractéristiques ressortiront plus clairement de l'exposé qui va suivre d'un mode de réalisation particulier de l'invention, donné à titre d'exemple non limitatif et représenté aux dessins annexés sur lesquels:

La figure 1 représente, sous forme de schéma - blocs, une installation comportant un dispositif selon l'invention.

La figure 2 représente un mode de réalisation particulier d'un organigramme pour la mise en oeuvre de l'invention.

Les figures 3 et 4 représentent respectivement les courbes de variation, en fonction du temps, de la tension aux bornes d'une batterie et des tensions mesurées aux bornes de certains de ses éléments.

La figure 5 illustre une phase additionnelle d'un mode particulier de réalisation de l'invention.

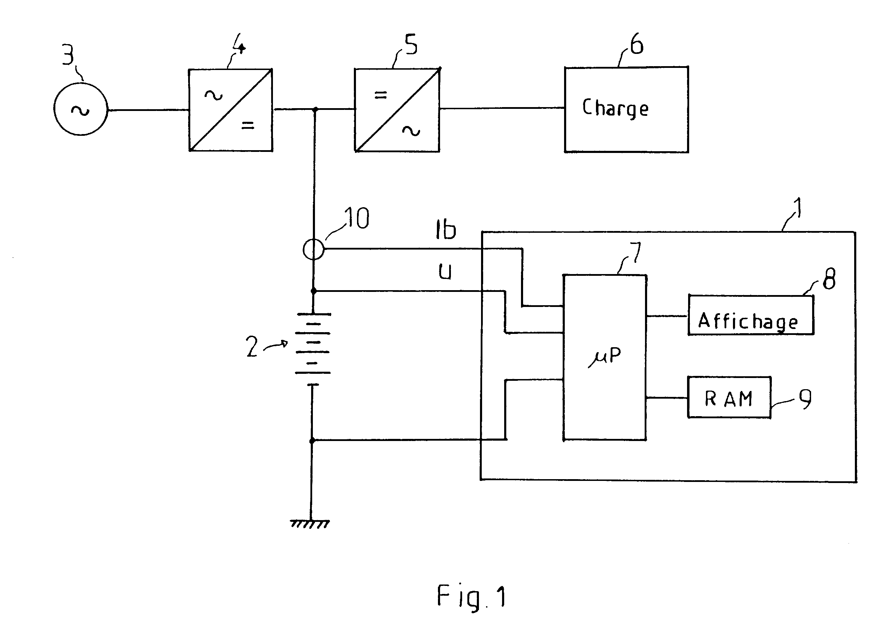

La figure 1 illustre l'application d'un dispositif 1 de détection de défaillance d'un ou plusieurs éléments d'une batterie à une batterie 2 d'une alimentation sans coupure. L'alimentation sans coupure, de type classique, représentée schématiquement sur la figure, est alimentée par une source 3 de tension alternative et comporte un convertisseur alternatif-continu 4 connecté en série avec un convertisseur continu-alternatif, ou onduleur, 5 et une charge 6, la batterie 2 étant connectée à la sortie du convertisseur 4.

Le dispositif 1 comporte un circuit électronique de traitement 7, à microprocesseur, connecté à un dispositif d'affichage 8. Le circuit électronique de traitement 7 reçoit en entrée des signaux représentatifs de la tension U aux bornes de la batterie.

Une défaillance d'un ou plusieurs éléments de la batterie se traduit, lors d'une décharge de la batterie, par une rupture de la pente de la courbe U(t) représentative de la tension U en fonction du temps. Une telle rupture de pente peut être décelée par le calcul de la dérivée seconde de la courbe U(t). En fonctionnement normal, la dérivée seconde de la tension est toujours négative au cours d'une décharge de la batterie. Si la dérivée seconde devient positive en cours de décharge, ceci est représentatif de la défaillance d'un ou plusieurs éléments de la batterie.

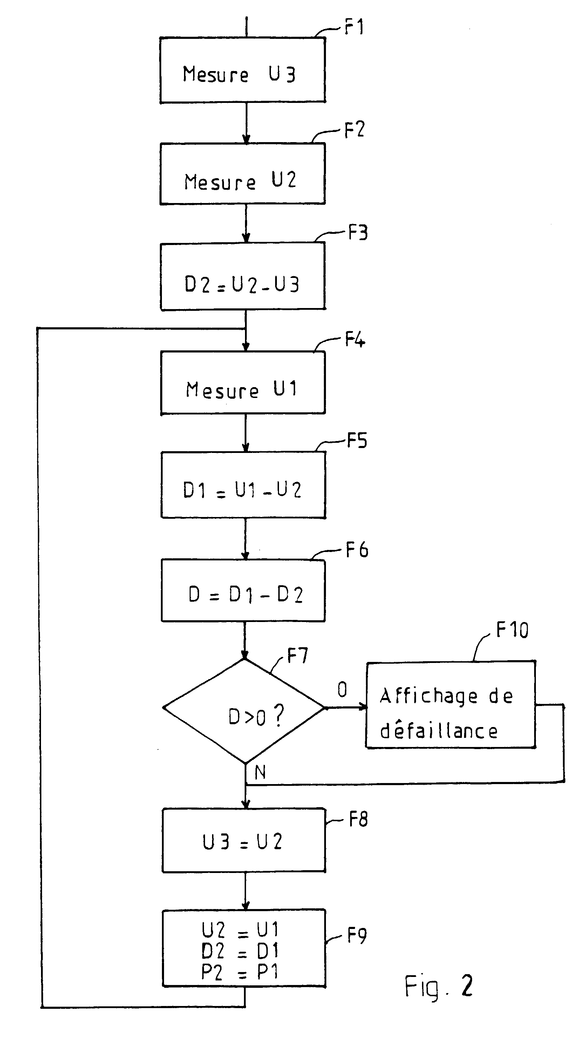

La figure 2 illustre un mode de réalisation préférentiel d'un organigramme pouvant être mis en oeuvre par le microprocesseur 7. Sur la figure 2, la détection de défaillance commence par une phase F1 d'une première mesure U3, par le microprocesseur 7, de la tension U aux bornes de la batterie 2. Cette phase F1 est suivie d'une phase F2 consistant en une seconde mesure U2 de la tension U aux bornes de la batterie après un intervalle de temps Δt prédéterminé. Puis le microprocesseur calcule (F3) la différence D2 entre U2 et U3. L'intervalle de temps Δt entre deux mesures successives étant prédéterminée, constante, la différence D2 est représentative de la dérivée de la courbe U(t).

Le microprocesseur effectue ensuite (F4) une troisième mesure U1 de la tension U aux bornes de la batterie 2, l'intervalle de temps Δt séparant les mesures de U1 et U2. Puis il calcule (F5) la différence D1 entre U1 et U2 et (F6) la différence D entre D1 et D2. La différence D est représentative de la dérivée seconde de la courbe U(t) constituée à partir des trois mesures successives U3, U2 et U1 de U effectuées à des intervalles de temps prédéterminés constants Δt et mises en mémoire, par exemple dans une RAM 9. Puis D est comparé à un seuil, de préférence zéro, pendant une phase F7.

Si D est inférieur au seuil (sortie N de F7), les éléments de la batterie sont considérés comme étant en bon état de fonctionnement. La seconde mesure U2 remplace (F8) la valeur U3 dans la mémoire 9 du circuit de traitement 7. Puis (F9) la première mesure U1 remplace la valeur U2 dans la mémoire 9 et la différence D1 remplace la différence D2. Ainsi, les deux dernières mesures sont mises en mémoire, ainsi que leur différence, et le microprocesseur peut recommencer un nouveau cycle de détermination de la dérivée seconde D en F4, par une nouvelle mesure de U1, l'intervalle de temps Δt séparant deux mesures U1 successives. A titre d'exemple non limitatif Δt peut être de l'ordre de 20 ou 30s.

De cette manière, la dérivée seconde est calculée automatiquement à chaque nouvelle mesure U1.

Si D est supérieur au seuil (sortie O de F7), une défaillance est signalée par exemple (F10) par affichage sur l'afficheur 8.

Bien entendu la signalisation peut être réalisée par tout autre moyens approprié, visuel ou acoustique, localement ou à distance.

Dans le mode de réalisation représenté à la figure 2, le seuil représentatif d'une défaillance est zéro. Pour éviter certaines alarmes intempestives il peut être préférable de choisir un seuil légèrement supérieur à zéro.

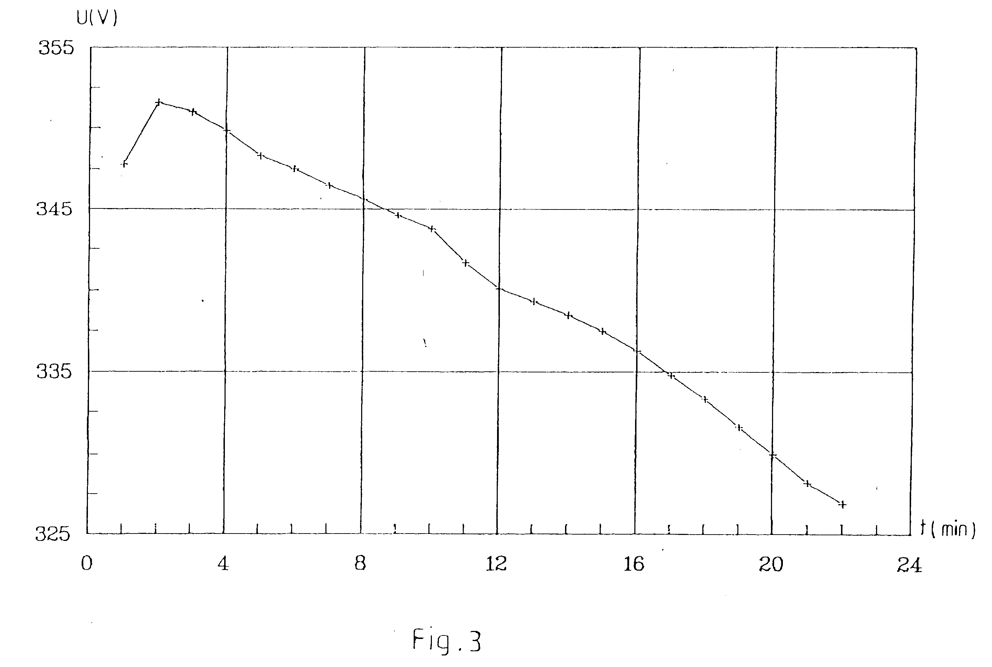

On peut montrer expérimentalement que la dérivé seconde D est bien représentative d'une défaillance. A titre d'exemple, la figure 3 représente une courbe U(t) de décharge obtenue expérimentalement aux bornes d'une batterie d'onduleur constituée de 29 monoblocs élémentaires.

Les valeurs successives de U, mesurées avec un intervalle de temps Δt de lmin, les valeurs successives de D1 et de D calculées sont telles qu'indiqué ci-dessous.

| t (mm) | U (V) | D1 | D |
|---|---|---|---|
| 1 | 347,7665 | | |
| 2 | 351,5218 | 3,8 | |
| 3 | 350,925 | -0,6 | -4,4 |
| 4 | 349,7962 | -1,1 | -0,5 |
| 5 | 348,2835 | -1,5 | -0,4 |
| 6 | 347,4759 | -0,8 | 0,7 |
| 7 | 346,4733 | -1,0 | -0,2 |
| 8 | 345,6198 | -0,9 | 0,1 |
| 9 | 344,5427 | -1,1 | -0,2 |
| 10 | 343,6921 | -0,9 | 0,2 |
| 11 | 341,6315 | -2,1 | -1,2 |
| 12 | 340,0479 | -1,6 | 0,5 |
| 13 | 339,2599 | -0,8 | 0,8 |
| 14 | 338,4148 | -0,8 | -0,1 |
| 15 | 337,4351 | -1,0 | -0,1 |
| 16 | 336,2036 | -1,2 | -0,3 |
| 17 | 334,727 | -1,5 | -0,2 |
| 18 | 333,2822 | -1,4 | 0,0 |
| 19 | 331,594 | -1,7 | -0,2 |
| 20 | 329,9797 | -1,6 | 0,1 |
| 21 | 328,1715 | -1,8 | -0,2 |
| 22 | 326,8366 | -1,3 | 0,5 |

On constate des anomalies (D > O) aux instants suivants :
6 - 8 - 10 - 12 - 13 - 18 et 20 min.

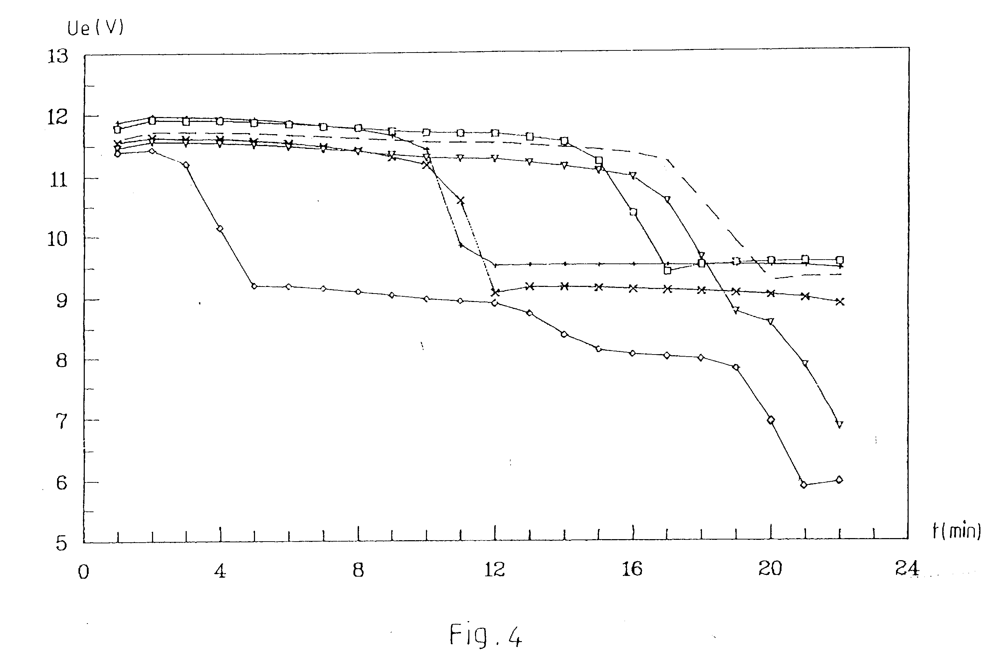

La figure 4 représente des courbes Ue (t) représentant l'évolution des tensions aux bornes de 5 monoblocs élémentaires pendant cette décharge. On observe des chutes de tension significatives (Ue< 10V) sur au moins l'un des monoblocs élémentaires aux instants suivants : 5 - 11 - 12 - 17 - 19 et 20 min. Les tensions aux bornes de monobloc élémentaires restants, non représentés, ne présentaient aucune chute significative.

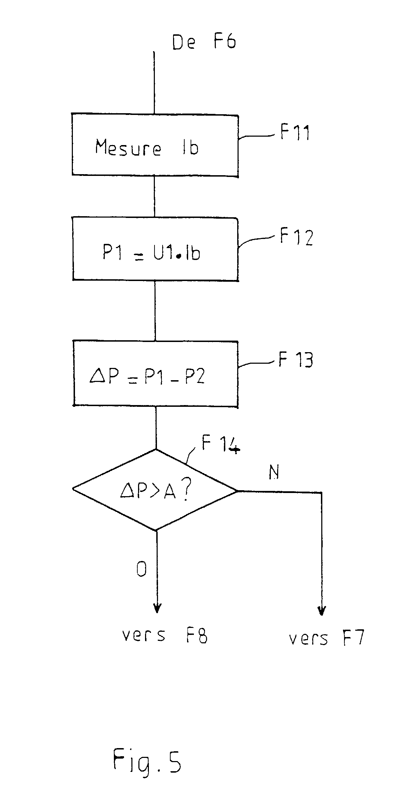

En cas de modification importante de la puissance débitée par la batterie, le calcul de la dérivée seconde peut conduire à des signalisations intempestives de défaillance. Il est donc préférable d'inhiber la signalisation dans un tel cas. Une phase additionnelle d'inhibition, telle que représentée à la figure 5, peut être intercalée, dans l'organigramme de la figure 2, par exemple après la phase F5 ou F6. Cette phase d'inhibition consiste à mesurer (F11) le courant Ib débité par la batterie, mesuré par un capteur de courant 10. Puis le microprocesseur calcule (F12) la puissance P1=U1·Ib débitée, et calcule (F13) la différence Δp entre cette puissance et la puissance mesurée lors du cycle de mesure précédent. Puis Δp est comparé (F14) à un seuil A prédéterminé. Si Δp n'est pas supérieur au seuil (sortie N de F14), le microprocesseur poursuit normalement l'organigramme de la figure 2 en passant à la phase F7. Par contre, si Δp est supérieur au seuil (sortie O de F14), les phases F7 et F10 sont court-circuitées et le microprocesseur passe directement à la phase F8, inhibant ainsi toute signalisation de défaillance. La phase F9 est alors complétée par la mise en mémoire de P1 en P2 pour le cycle suivant.

Le dispositif de détection décrit ci-dessus peut éventuellement être combiné à un dispositif à microprocesseur de détermination de l'autonomie de batterie. En effet, un tel dispositif détermine l'autonomie d'une batterie à partir de mesures de sa tension U et du courant Ib débité par la batterie et du calcul de la puissance débitée. Il suffit alors de compléter l'organigramme existant par un calcul de la dérivée seconde et sa comparaison à un seuil prédéterminé pour permettre une signalisation de la défaillance d'un ou plusieurs éléments de batterie.

## Revendications

1. Dispositif de détection de défaillance d'éléments de batterie comportant des moyens de mesure, pendant la décharge de la batterie, de la tension (U1, U2, U3) aux bornes de la batterie, dispositif caractérisé en ce qu'il comporte des moyens de calcul d'une grandeur (D) représentative de la dérivée seconde de ladite tension, des moyens de comparaison de ladite grandeur représentative de la dérivée seconde à un seuil prédéterminé, positif ou nul, et des moyens (8) de signalisation d'une défaillance lorsque ladite grandeur (D) est supérieure audit seuil.

2. Dispositif selon la revendication 1, caractérisé en ce que les moyens de mesure de la tension comportent des moyens de mesure de la tension à des intervalles de temps (Δt) prédéterminés et des moyens (9) de mise en mémoire de trois valeurs successives (U3, U2, U1) de la tension.

3. Dispositif selon la revendication 2, caractérisé en ce que les moyens de calcul de la grandeur (D) représentative de la dérivée seconde comportent des moyens de calcul d'une grandeur (D1, D2) représentative de la dérivée première de la tension.

4. Dispositif selon la revendication 3, caractérisé en ce que les moyens de calcul de la grandeur (D1, D2) représentative de la dérivée première comportent des moyens de calcul de la différence entre deux valeurs (U1, U2) successives de tension.

5. Dispositif selon la revendication 4, caractérisé en ce que les moyens de calcul de la grandeur (D) représentative de la dérivée seconde comportent des moyens de calcul de la différence entre deux valeurs successives (D1, D2) de la grandeur représentative de la dérivée première.

6. Dispositif selon l'une quelconque des revendications 1 à 5, caractérisé en ce que les moyens de calcul comportent un microprocesseur (7).

7. Dispositif selon l'une quelconque des revendications 1 à 6, caractérisé en ce qu'il comporte des moyens (10) de mesure du courant (Ib) de décharge de la batterie, des moyens de calcul de la puissance (P1, P2) débitée par la batterie, des moyens de mise en mémoire de la puissance (P2) précédemment débitée par la batterie, des moyens de calcul de la différence (ΔP) entre deux valeurs successives (D1, P2) de la puissance, des moyens de comparaison de la différence (ΔP) de puissance à un seuil de puissance (A) prédéterminé et des moyens d'inhibition de l'affichage de défaillance si la différence de puissance (ΔP) est supérieure audit seuil de puissance (A).

## Patentansprüche

1. Anordnung zur Erfassung eines Fehlers in Batterieblöcken, welche Mittel zur Messung der Spannung (U1, U2, U3) an den Klemmen der Batterie während der Entladung der Batterie umfaßt, dadurch gekennzeichnet, daß die Anordnung Mittel zur Berechnung einer, die zweite Ableitung der genannten Spannung abbildenden Größe (D), Mittel zum Vergleich der genannten, die zweite Ableitung abbildenden Größe mit einem festgelegten Schwellwert, welcher positiv oder null ist, sowie Mittel (8) zur Anzeige eines Fehlers bei Überschreiten des genannten Schwellwerts durch die genannte Größe (D) umfaßt.

2. Anordnung nach Anspruch 1, dadurch gekennzeichnet, daß die Mittel zur Messung der Spannung Mittel zur Messung der Spannung in bestimmten Zeitintervallen (Δt) sowie Mittel (9) zur Abspeicherung von drei aufeinanderfolgenden Werten (U3, U2, Ul) umfassen.

3. Anordnung nach Anspruch 2, dadurch gekennzeichnet, daß die Mittel zur Berechnung der die zweite Ableitung abbildenden Größe (D) Mittel zur Berechnung einer, die erste Ableitung der Spannung abbildenden Größe (D1, D2) umfassen.

4. Anordnung nach Anspruch 3, dadurch gekennzeichnet, daß die Mittel zur Berechnung der die erste Ableitung abbildenden Größe (D1, D2) Mittel zur Berechnung der Differenz zwischen zwei aufeinanderfolgenden Spannungswerten (U1, U2) umfassen.

5. Anordnung nach Anspruch 4, dadurch gekennzeichnet, daß die Mittel zur Berechnung der die zweite Ableitung abbildenden Größe (D) Mittel zur Berechnung der Differenz zwischen zwei aufeinanderfolgenden Werten (D1, D2) der die erste Ableitung abbildenden Größe umfassen.

6. Anordnung nach einem der Ansprüche 1 bis 5, dadurch gekennzeichnet, daß die Berechnungsmittel einen Mikroprozessor (7) umfassen.

7. Anordnung nach irgendeinem der Ansprüche 1 bis 6, dadurch gekennzeichnet, daß sie Mittel (10) zur Messung des Entladestroms (Id) der Batterie, Mittel zur Berechnung der von der Batterie abgegebenen Leistung (P1, P2), Mittel zur Abspeicherung der zuvor von der Batterie abgegebenen Leistung (P2), Mittel zur Berechnung der Differenz (ΔP) zwischen zwei aufeinanderfolgenden Leistungswerten (P1, P2), Mittel zum Vergleich der Leistungsdifferenz (ΔP) mit einem festgelegten Leistungs-Schwellwert (A) sowie Mittel zur Unterdrückung der Anzeige eines Fehlers bei Überschreiten des genannten Leistungs-Schwellwerts (A) durch die Leistungsdifferenz (ΔP) umfaßt.

## Claims

1. A device for detecting failure of battery cells comprising means for measuring the voltage (U1, U2, U3) at the battery terminals during discharge of the battery, a device characterized in that it comprises means for computing a quantity (D) representative of the second derivative of said voltage, means for comparing said quantity representative of the second derivative to a preset threshold, which is positive or zero, and means (8) for indicating a failure when said quantity (D) is greater than said threshold.

2. The device according to claim 1, characterized in that the means for measuring the voltage comprise means for measuring the voltage at preset time intervals (Δt) and means (9) for storing three successive values (U3, U2, U1) of the voltage.

3. The device according to claim 2, characterized in that the means for computing the quantity (D) representative of the second derivative comprise means for computing a quantity (D1, D2) representative of the first derivative of the voltage.

4. The device according to claim 3, characterized in that the means for computing the quantity (D1, D2) representative of the first derivative comprise means for computing the difference between two successive voltage values (U1, U2).

5. The device according to claim 4, characterized in that the means for computing the quantity (D) representative of the second derivative comprise means for computing the difference between two successive values (D1, D2) of the quantity representative of the first derivative.

6. The device according to any one of the claims 1 to 5, characterized in that the means for computing comprise a microprocessor (7).

7. The device according to any one of the claims 1 to 6, characterized in that it comprises means (10) for measuring the battery discharge current (Ib), means for computing the power (P1, P2) delivered by the battery, means for storing the power (P2) previously delivered by the battery, means for computing the difference (ΔP) between two successive power values (P1, P2), means for comparing the power difference (ΔP) to a preset power threshold (A) and means for disabling failure display if the power difference (ΔP) is greater than said preset power threshold (A).
